Europäisches Patentamt

European Patent Office

Office européen des brevets

(19)

(11) Numéro de publication : **0 115 460**
**B1**

(12) **FASCICULE DE BREVET EUROPÉEN**

(45) Date de publication du fascicule du brevet :
19.08.87

(21) Numéro de dépôt : **84400150.3**

(22) Date de dépôt : **24.01.84**

(51) Int. Cl.⁴ : **H 05 K   3/36**, H 05 K   3/22

(54) **Carte souple de circuit imprimé, procédé de modification d'une carte de circuit imprimé, et carte modifiée de circuit imprimé.**

(30) Priorité : 31.01.83 FR 8301452

(43) Date de publication de la demande :
08.08.84 Bulletin 84/32

(45) Mention de la délivrance du brevet :
19.08.87 Bulletin 87/34

(84) Etats contractants désignés :
CH DE GB IT LI NL SE

(56) Documents cités :
FR-A- 2 453 509
GB-A- 1 511 560
GB-A- 2 047 476

(73) Titulaire : **COMPAGNIE D'INFORMATIQUE MILITAIRE SPATIALE ET AERONAUTIQUE**
**25, rue de Courcelles**
**F-75008 Paris (FR)**

(72) Inventeur : **Servol, Jacques**
**THOMSON-CSF SCPI 173, bld Haussmann**
**F-75379 Paris Cedex 08 (FR)**
Inventeur : **Tonella, Claude**
**THOMSON-CSF SCPI 173, bld Haussmann**
**F-75379 Paris Cedex 08 (FR)**

(74) Mandataire : **Benoit, Monique et al**
**THOMSON-CSF SCPI 19, avenue de Messine**
**F-75008 Paris (FR)**

## Description

La présente invention concerne une carte souple de circuit imprimé, son utilisation dans un procédé de modification d'une carte en général rigide de circuit imprimé et enfin une carte de circuit imprimé modifiée selon ce procédé.

Le problème technique posé est celui des modifications des cartes de circuit imprimé, simple ou multicouche, que ces cartes soient nues ou équipées de composants.

Selon une technique connue actuellement, les nouvelles liaisons à établir entre différents points du circuit imprimé pour modifier son tracé initial sont réalisées par des tissages en fils isolés dans des gaines protectrices, implantés sur la face soudure de la carte et fixés par des points de colle.

Ce procédé de modification d'une carte de circuit imprimé présente, outre le coût élevé des tissages, notamment les inconvénients suivants. Les tissages étant soudés sur la face soudure de la carte, il est nécessaire d'en vérifier la bonne implantation par rapport aux composants déjà mis en place sur l'autre face, ce qui entraîne un contrôle supplémentaire.

Pour certains pas d'implantation de cartes, dans une armoire spéciale par exemple, les tissages d'une carte peuvent être accrochés par les composants de la carte voisine. A cela, il faut ajouter un aspect peu fini de la carte ainsi modifiée.

Le but de la présente invention est de pallier ces inconvénients dus aux tissages sans qu'il soit cependant nécessaire de reprendre l'étude d'implantation et de cheminement des pistes d'une carte. Une telle étude est coûteuse car elle demande la reprise totale des couches logiques, c'est-à-dire des pistes de la carte, suivie d'une validation électrique de la nouvelle carte après modifications.

L'objet de la présente invention permet de modifier de façon simple, industrielle et peu coûteuse une carte de circuit imprimé. Pour cela, il concerne une carte souple de circuit imprimé, comportant un substrat isolant recouvert sur une première face de dépôts conducteurs formant les pistes du circuit imprimé, caractérisée en ce qu'elle comporte en outre sur une seconde face opposée à la première, une couche de matériau adhésif transfert.

Selon une autre caractéristique de l'invention, la carte souple de circuit imprimé est constituée d'un substrat isolant recouvert, sur chacune de ses deux faces opposées l'une à l'autre, de dépôts conducteurs formant les pistes du circuit imprimé, et elle comporte en outre, sur une des couches de dépôts conducteurs, une couche de matériau adhésif transfert.

Selon l'invention également, le procédé de modification d'une carte de circuit imprimé consiste à reporter sur cette dernière une carte souple selon l'invention, la couche de matériau adhésif transfert de celle-ci étant placée en vis-à-vis de la face soudure de celle-là.

D'autres caractéristiques et avantages de l'invention apparaîtront dans la description qui suit, illustrée sur les figures suivantes représentant :

les figures 1 et 2 deux coupes transversales d'une carte souple de circuit imprimé selon l'invention ;

les figures 3 et 5 deux coupes transversales d'une carte de circuit imprimé modifiée à l'aide d'une carte selon l'invention ;

la figure 4 un exemple de tracé du circuit de modification.

Comme cela a été dit auparavant, l'objet de l'invention est de réaliser une carte de circuit imprimé simple ou double face, d'épaisseur très faible pour avoir une certaine souplesse et qui prend en compte les liaisons de modification d'une carte rigide de circuit imprimé. Cette carte souple est autocollante et, son collage sur la face soudure de la carte à modifier s'effectuant par une simple pression, constitue un procédé de modification très intéressant.

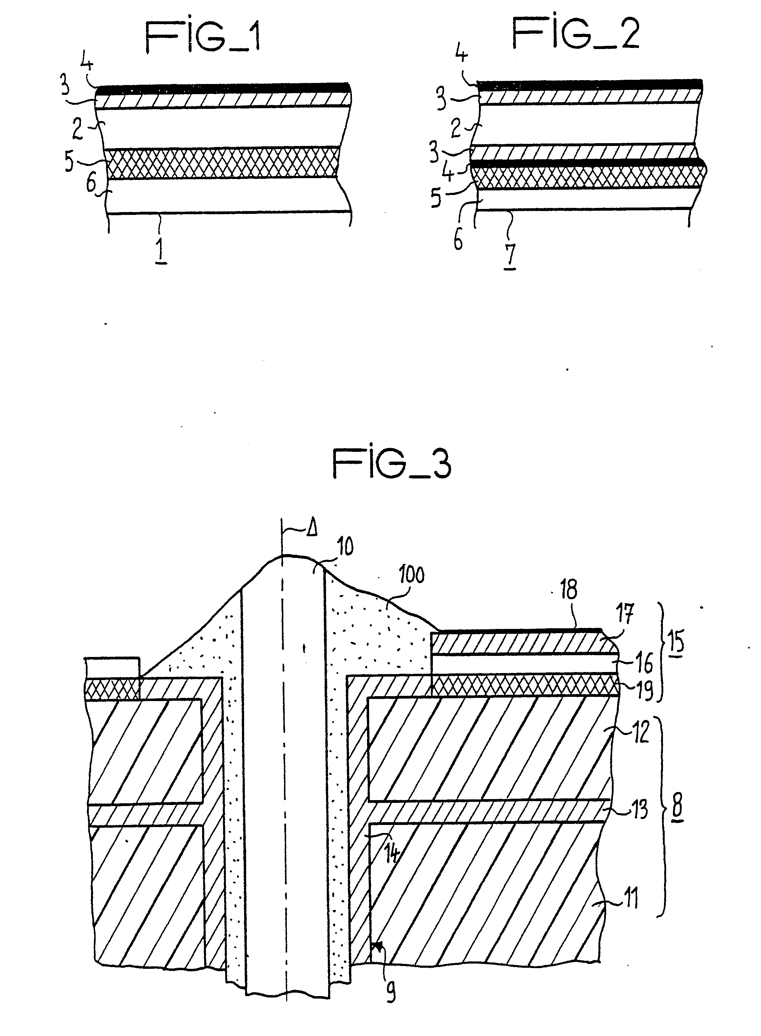

La figure 1 représente une coupe transversale d'une carte souple simple face, selon l'invention. Cette carte 1 est réalisée à partir d'un substrat isolant 2 recouvert sur une première face par des dépôts conducteurs 3 formant les pistes du circuit imprimé, éventuellement recouverts par une couche protectrice 4 évitant l'oxydation et facilitant les soudures. Sur la seconde face, opposée à la première, est appliquée une couche de matériau adhésif transfert 5. On appelle matériau adhésif transfert ou bien encore matériau à transfert d'adhésif, une colle pure, sans agent de support. Pour maintenir les qualités de l'adhésif et faciliter les manipulations de la carte souple 1, cette couche de matériau adhésif 5 est recouverte d'un film protecteur, autrement appelé intercalaire.

La figure 2 représente une coupe transversale d'une carte souple double face, selon l'invention. Cette carte 7 comporte, comme précédemment, un substrat isolant 2, comportant sur ses deux faces, opposées l'une à l'autre, des dépôts conducteurs 3 éventuellement recouverts d'une couche protectrice 4. Sur une de ses couches conductrices est reportée une couche de matériau adhésif transfert 5. Comme précédemment, cette couche de matériau adhésif 5 est protégée par un film 6 lors des manipulations.

Dans les deux cas, simple et double face, les dépôts de matériau conducteur 3 constituent les circuits imprimés de modification. Ils sont imprimés sur le substrat isolant selon un procédé connu. Lorsque des trous doivent être percés sur toute l'épaisseur de la carte souple selon l'invention, l'adhésif est percé en même temps que la carte, une fois collé sur celle-ci si elle est du type simple face, mais revêtu de part et d'autre par un film protecteur si la carte est double face. Dans ce dernier cas, la couche d'adhésif transfert est reportée sur une des faces de la carte souple à l'issue de la réalisation du circuit imprimé en vis-à-vis.

Selon un mode de réalisation pratique, la carte souple selon l'invention est réalisée à partir d'une couche de matériau isolant standard, du type Kapton ou verre-époxy FR4, d'épaisseur comprise entre 50 et 100 micromètres, sur au moins une des faces de laquelle est imprimé un circuit constitué de pistes de cuivre laminé d'épaisseur inférieure ou égale à 35 microns. Pour éviter une oxydation du cuivre et pour y retenir la soudure, les pistes sont recouvertes d'une couche d'étain-plomb.

La couche de matériau d'adhésif transfert utilisée préférentiellement se caractérise d'abord par son adhésif qui est de l'acrylique et par sa masse adhésive très ferme pour une meilleure cohésion interne et présentant une bonne résistance au cisaillement.

Une application particulièrement intéressante d'une telle carte selon l'invention consiste à l'utiliser dans un procédé de modification des cartes en général rigides de circuits imprimés, qu'elles soient nues ou équipées de composants. Lors de ce procédé, on reporte une carte souple sur la carte à modifier, la couche de matériau adhésif transfert étant placée en vis-à-vis de la face soudure de la carte à modifier. Le collage des deux cartes s'effectue par simple pression, même mauelle, le film protecteur étant ôté.

De façon préférentielle, pour une meilleure adhésion, la couche d'adhésif aura les mêmes dimensions que la carte souple.

La figure 3 représente une coupe transversale d'une carte 8 de circuit imprimé modifiée à l'aide de l'objet de l'invention. La coupe se situe au niveau d'un trou 9 perçant la carte sur toute son épaisseur et à l'intérieur duquel est introduite une patte 10 — ou soie — de composant.

La carte multicouche 8 à modifier est constituée de plusieurs couches de matériau isolant, dont deux 11 et 12 sont représentées, entre lesquelles sont déposées les pistes 13 des circuits imprimés. Pour assurer une bonne connexion électrique entre les pistes et la patte du composant, le trou 9 est métallisé sur toute sa longueur par une couche 14 de cuivre étamé retenant la soudure tout le long de la patte.

Les modifications de cette carte 8 sont apportées par collage d'une carte souple 15 simple face selon l'invention. Elle comporte, comme cela a été précédemment décrit, une couche de matériau isolant 16 sur une face de laquelle sont imprimés les circuits conducteurs 17 (pistes ou pastilles) de modification — elles peuvent être éventuellement protégées par une couche 18 d'étain-plomb. Sur la face opposée aux pistes 17 se trouve la couche d'adhésif transfert 19 collée par simple pression à la face soudure de la carte à modifier.

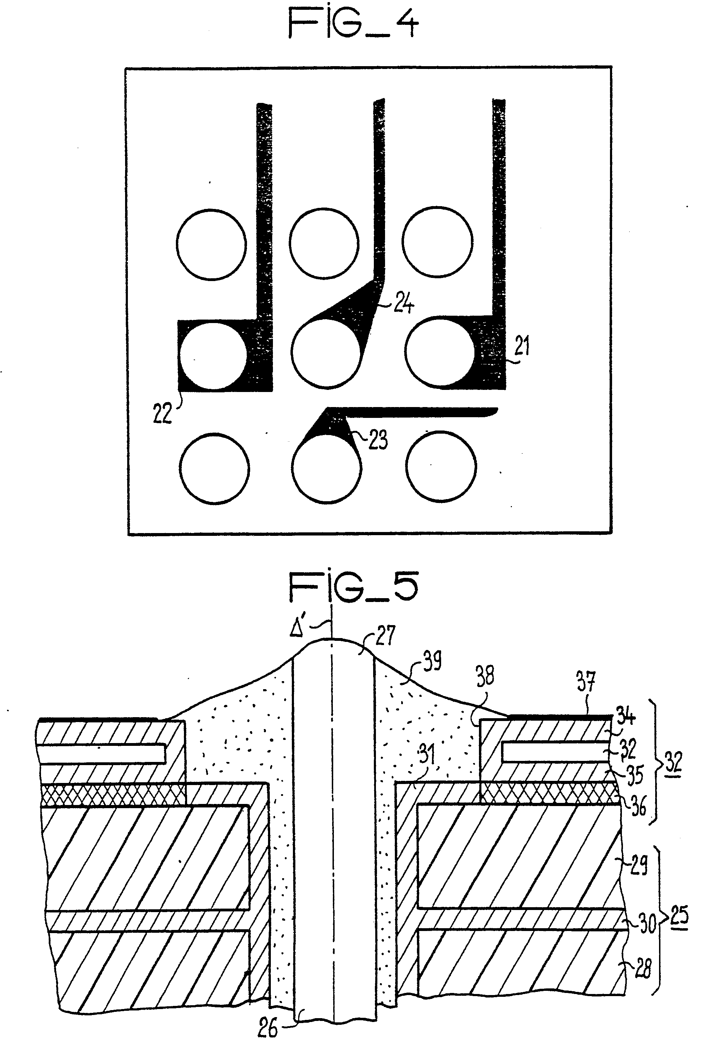

Les pastilles conductrices assurant les liaisons entre un trou et un autre point du circuit imprimé n'entourent pas toujours totalement le trou ; c'est ce qui est représenté sur la figure 4 et c'est ce qui explique la dissymétrie de la figure 3 par rapport à un axe de symétrie du trou 9. Elles peuvent être rectangulaires (21 et 22) ou arrondies (23 et 24).

Une fois la carte souple 15 collée à la carte 8 à modifier, les composants sont soudés selon un procédé connu, de brasage à la vague par exemple. La soudure 100 est représentée en pointillés sur la figure 3.

La figure 5 représente une coupe transversale d'une carte 25 de circuit imprimé modifiée à l'aide d'une carte souple double face, selon l'invention. Comme pour la figure 3, la coupe se situe au niveau d'un trou 26 perçant la carte sur toute son épaisseur et dans lequel est introduite une soie de composant 27.

La carte multicouche 25 à modifier comporte au moins deux couches de matériau isolant 28 et 29 entre lesquelles sont déposés les circuits imprimés 30. La continuité électrique entre les circuits imprimés et la patte du composant est assurée par une métallisation du trou sur toute sa longueur, au moyen d'une couche 31 de cuivre étamé retenant la soudure.

Sur cette carte 25 est collée une carte souple double face 32 selon l'invention. Comme cela a été dit à propos de la description de la figure 2, cette carte 25 comporte une couche 33 de matériau isolant, métallisée sur ses deux faces par deux couches de cuivre 34 et 35, réalisant les circuits de modification, et sur des couches de laquelle est collée une couche d'adhésif transfert 36, assurant l'adhésion entre cette carte souple 32 et la carte à modifier 25. Eventuellement, la couche supérieure 34 de cuivre peut être recouverte par une couche 37 d'étain-plomb protecteur. Le trou 38 réalisé dans la carte souple 32 a un diamètre supérieur à celui réalisé dans la carte 25 et est également métallisé de sorte qu'une fois la soudure 39 coulée dans le trou le long de la patte du composant, une bonne connexion électrique est obtenue entre les différents circuits imprimés et le composant.

Le fait d'utiliser une carte souple de circuit imprimé selon l'invention pour modifier des cartes rigides existantes, nues ou équipées de composants, présente trois principaux avantages.

Premièrement, le procédé est plus industriel que celui qui consiste à reporter des tissages et moins coûteux pour des cartes à modifier nécessitant au moins dix tissages.

Deuxièmement, grâce à ce procédé, il n'est plus nécessaire de reprendre l'étude d'implantation et la validation électrique de la carte à modifier ; les exemplaires déjà réalisés et stockés sont utilisés, ce qui entraîne un gain de temps et d'argent considérable.

Enfin, l'aspect final de la carte modifiée n'est plus altéré par les tissages et ses manipulations en sont simplifiées.

**Revendications**

1. Carte souple de circuit imprimé, comportant un substrat isolant (2) recouvert sur une première face de dépôts conducteurs (3) formant les pistes du circuit imprimé, caractérisée en ce qu'elle comporte en outre sur une seconde face opposée à la première, une couche (5) de matériau adhésif transfert.

2. Carte souple de circuit imprimé, comportant un substrat isolant (2) recouvert, sur chacune de ses deux faces opposées l'une à l'autre, de dépôts conducteurs formant les pistes du circuit imprimé, caractérisée en ce qu'elle comporte en outre, sur une des couches de dépôts conducteurs, une couche (5) de matériau adhésif transfert.

3. Carte selon l'une des revendications 1 ou 2, caractérisée en ce que la couche (5) de matériau adhésif transfert est recouverte d'un film protecteur (6).

4. Carte selon l'une des revendications 1, 2 ou 3, caractérisée en ce que la couche (5) de matériau adhésif transfert a les mêmes dimensions que la carte.

5. Carte selon la revendication 2, caractérisée en ce qu'elle est percée de trous métallisés.

6. Procédé de modification d'une carte de circuit imprimé comprenant une première face d'implantation des composants et une seconde face opposée à la première sur laquelle sont réalisées les soudures de ces composants à la carte, caractérisé en ce qu'il comporte une étape de report d'une carte souple selon l'une des revendications 1 à 5 sur la carte à modifier, sa couche de matériau adhésif transfert étant placée en vis-à-vis de la face soudure de la carte à modifier.

7. Carte de circuit imprimé comprenant une première face d'implantation des composants et une seconde face opposée à la première sur laquelle sont réalisées les soudures de ces composants à la carte, caractérisée en ce qu'elle comporte une carte souple selon l'une des revendications 1 à 5 reportée de sorte que sa couche de matériau adhésif transfert soit placée en vis-à-vis de la face soudure de la carte à modifier.

## Claims

1. Flexible printed circuit board comprising an insulating substrate (2), covered on a first side with conductive deposits (3) forming the pattern of the printed circuit, characterized in that it further comprises on a second face opposite to the first a layer (5) of adhesive transfer material.

2. Flexible printed circuit board comprising an insulating substrate (2) covered on each of its two opposed faces with conductive deposits forming the pattern of the printed circuit, characterized in that it further comprises on one of the layers of conductive deposits a layer (5) of adhesive transfer material.

3. Board according to any of claims 1 and 2, characterized in that the layer (5) of adhesive transfer material is covered with a protective film (6).

4. Board according to any of claims 1, 2 and 3, characterized in that the layer (5) of adhesive transfer material has the same dimensions as the board.

5. Board according to claim 2, characterized in that it is provided with pierced metallized holes.

6. Method of modifying a printed circuit board comprising a first face for implanting components and a second face opposite the first whereon the soldering connections of the components with the board are performed, characterized in that it comprises a step of transferring a flexible board according to any of claims 1 to 5 to the board to be modified, its layer of adhesive transfer material being placed in facing relationship to the soldering face of the board to be modified.

7. Printed circuit board comprising a first face for implanting components and a second face opposite the first whereon the soldering connections of these components with the board are performed, characterized in that it comprises a flexible board according to any of claims 1 to 5 transferred in such a manner that its layer of adhesive transfer material is located in facing relationship to the soldering face of the board to be modified.

## Patentansprüche

1. Flexible gedruckte Schaltungskarte, mit einem Isoliersubstrat (2), das auf einer ersten Fläche mit aufgebrachten Leitern (3) versehen ist, welche die Bahnen der gedruckten Schaltung bilden, dadurch gekennzeichnet, daß sie ferner auf einer zweiten, der ersten gegenüberliegenden Seite eine Schicht (5) aus einem haftenden Übertragungsmaterial aufweist.

2. Flexible gedruckte Schaltungskarte, mit einem Isoliersubstrat (2), das auf einer seiner beiden einander gegenüberliegenden Flächen mit aufgebrachten Leitern versehen ist, welche die Bahnen der gedruckten Schaltung bilden, dadurch gekennzeichnet, daß sie ferner auf einer der Schichten von aufgebrachten Leitern eine Schicht (5) aus haftendem Übertragungsmaterial aufweist.

3. Karte nach Anspruch 1 oder 2, dadurch gekennzeichnet, daß die Schicht (5) aus haftendem Übertragungsmaterial mit einem Schutzfilm (6) bedeckt ist.

4. Karte nach Anspruch 1, 2 oder 3, dadurch gekennzeichnet, daß die Schicht (5) aus haftendem Übertragungsmaterial die gleichen Abmessungen wie die Karte aufweist.

5. Karte nach Anspruch 2, dadurch gekennzeichnet, daß sie von metallisierten Löchern durchbrochen ist.

6. Verfahren zum Verändern einer gedruckten Schaltungskarte, die eine erste Fläche zum Einsetzen von Bauteilen und eine zweite, der ersten gegenüberliegende Fläche aufweist, auf welcher die Lötverbindungen dieser Bauteile mit der Karte hergestellt werden, dadurch gekennzeichnet, daß es einen Verfahrensschritt umfaßt, bei welchem eine flexible Karte nach einem der Ansprüche 1 bis 5 auf die zu verändernde Karte überführt wird, wobei ihre Schicht aus haftendem Übertragungsmaterial in Gegenüberstellung zu der Lötfläche der zu verändernden Karte gebracht wird.

7. Gedruckte Schaltungskarte mit einer ersten Fläche zum Einsetzen von Bauteilen und einer zweiten, der ersten gegenüberliegenden Fläche, auf welcher die Lötverbindungen dieser Bauteile mit der Karte hergestellt werden, dadurch gekennzeichnet, daß sie eine flexible Karte nach einem der Ansprüche 1 bis 5 umfaßt, die in einer solchen Weise aufgesetzt wurde, daß ihre Schicht aus haftendem Übertragungsmaterial in Gegenüberstellung zu der Lötseite der zu verändernden Karte gebracht wurde.

FIG_1

FIG_2

FIG_3

# FIG_4

# FIG_5